**Europäisches Patentamt**

**European Patent Office**

**Office européen des brevets**

(11) Numéro de publication : **0 445 008 A1**

# DEMANDE DE BREVET EUROPEEN

(21) Numéro de dépôt : **91400484.1**

(22) Date de dépôt : **22.02.91**

(51) Int. Cl.⁵ : **H01L 21/82, H01L 21/20, H01L 21/335, H01L 27/108**

(30) Priorité : **27.02.90 FR 9002418**

(43) Date de publication de la demande :
**04.09.91 Bulletin 91/36**

(84) Etats contractants désignés :
**DE FR GB IT**

(71) Demandeur : **THOMSON-CSF**
**51, Esplanade du Général de Gaulle**
**F-92800 Puteaux (FR)**

(72) Inventeur : **Weisbuch, Claude**
**THOMSON-CSF SCPI Cédex 67**
**F-92045 Paris La Défense (FR)**
Inventeur : **Pribat, Didier**
**THOMSON-CSF SCPI Cédex 67**
**F-92045 Paris La Défense (FR)**
Inventeur : **Cappelletti, Paolo**
**THOMSON-CSF SCPI Cédex 67**
**F-92045 Paris La Défense (FR)**

(74) Mandataire : **Guérin, Michel et al**
**THOMSON-CSF SCPI**
**F-92045 PARIS LA DEFENSE CEDEX 67 (FR)**

(54) **Procédé de réalisation de dispositifs électroniques haute densité.**

(57)      L'invention concerne un procédé de réalisation d'une matrice de filaments (2) et de construction d'une mémoire DRAM sur chaque filament.

Par dépôts successifs et attaques successives, on réalise le condensateur C de la mémoire DRAM, ainsi que le transistor de commande de la mémoire. Chaque filament étant en semiconducteur dopé, on réalise sur chaque filament le drain D, la grille G et la source S d'un transistor. On réalise ensuite des conducteurs de lignes et de commandes permettant une commande matricielle.

L'invention est également applicable à la réalisation de transistors à base perméable.
Application : Réalisation de mémoires et de transistors haute densité (400 Mbits/cm²).

FIG_4

EP 0 445 008 A1

# PROCEDE DE REALISATION DE DISPOSITIFS ELECTRONIQUES HAUTE DENSITE

L'invention concerne un procédé de réalisation de dispositifs électroniques haute densité et notamment de mémoires DRAM obtenues par épitaxie ou de transistors à base perméable.

La réalisation de mémoire DRAM à grande intégration pour le stockage d'information nécessite de réaliser sur des dimensions de plus en plus petites des condensateurs ayant une capacité de l'ordre de 30 fF. Pour atteindre une telle valeur en n'occupant qu'une surface de l'ordre de quelques (microns)$^2$ par élément de mémoire sur la puce, deux solutions sont actuellement développées : la cellule mémoire en tranchée et la cellule mémoire empilée. De plus, afin d'économiser la place utilisée pour chaque bit mémoire, on utilise un transistor à grille concentrique placé au-dessus de la capacité dans le cas de la cellule en tranchée. La présente invention concerne un nouveau mode de fabrication d'un élément mémoire similaire à celui d'un élément mémoire en tranchée, qui permettra d'occuper des surfaces inférieures à 1 $\mu m^2$.

Les technologies actuelles définissent l'élément mémoire par un pilier de silicium obtenu en creusant un substrat de silicium (voir document Sunouchi et al, Toshiba, IEDM digest 89, p. 23). Nous proposons de réaliser un tel pilier par croissance sur un substrat plan, et de réaliser ensuite toutes les opérations menant à l'obtention d'un élément mémoire sur ce pilier.

Il est connu qu'un certain nombre de méthodes mènent à la croissance de filaments cristallins (whiskers) de silicium d'excellente qualité. Parmi celles-ci, la croissance par décomposition CVD du Silane $SiH_4$ sur substrat texturé ou orienté.

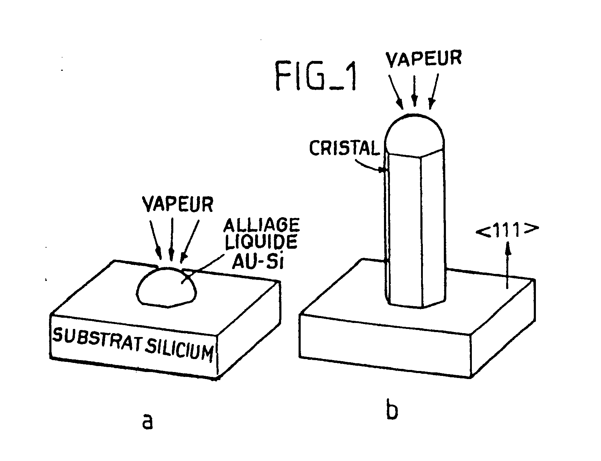

Un mécanisme très efficace utilise une phase liquide dans lequel le silicium est soluble au sommet du whisker : l'absorption de silicium dans le liquide produit une sursaturation de celui-ci qui condense alors le silicium à l'interface liquide-solide de façon à revenir à l'équilibre. La goutte de liquide s'élève peu à peu sur le cristal expulsé qui prend la forme d'un whisker de diamètre égal à la goutte de liquide (figures 1a et 1b). Celle-ci peut avoir de multiples compositions. Des compositions Au-Si et Ga-Si ont par exemple été démontrées.

La croissance peut être faite sur silicium, SOI, saphir $ZrO_2$ cubique, spinelle etc... On peut utiliser un substrat, texturé ou orienté (comme dans le cas du silicium recristallisé localement). On peut ainsi obtenir des whiskers sur des substrats conducteurs ou isolants suivant le besoin.

Cependant il n'est pas évident d'utiliser cette technique pour réaliser une mémoire car cela suppose de localiser avec précision la position de chaque filament cristallin (whiskers) pour construire autour de ce filament les différents éléments constitutifs de la mémoire.

C'est pourquoi l'invention concerne un procédé de réalisation de dispositifs électroniques caractérisé en ce qu'il comporte les étapes suivantes :
- une étape de réalisation sur une surface d'un substrat d'au moins un filament cristallin sensiblement perpendiculaire à la surface du substrat ;
- une étape de réalisation autour de chaque filament d'un composant électronique ;
- une étape de planarisation au niveau de la partie supérieure des filaments à l'aide d'un matériau isolant ;
- une étape de réalisation de contacts à la partie supérieure de chaque filament.

Les différents objets et caractéristiques de l'invention apparaîtront plus clairement dans la description qui va suivre et dans les figures annexées qui représentent :
- les figures 2a à 2f, un procédé de réalisation d'éléments filamentaires monocristallins selon l'invention ;
- les figures 3a à 3m, un procédé de réalisation d'une mémoire DRAM selon l'invention.
- la figure 4, une mémoire DRAM obtenue par le procédé de l'invention ;
- les figures 5 à 8, des exemples de réalisation de transistors à base perméable.

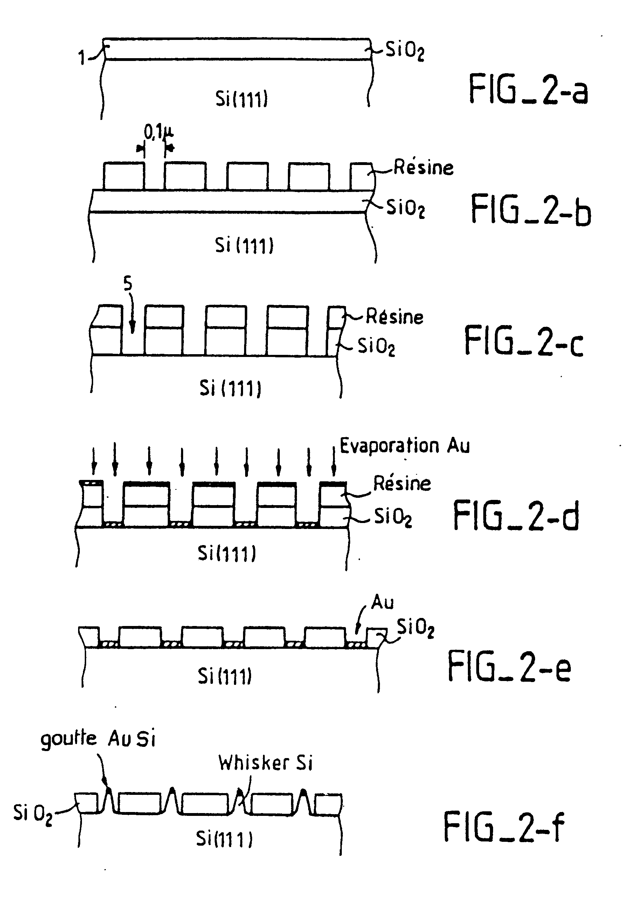

En se reportant aux figures 2a à 2g on va tout d'abord décrire le procédé de base selon l'invention.

On utilise comme cela est représenté en figure 2a un substrat de Si par exemple ou de GaAs, d'orientation de préférence (111) sur lequel on dépose (ou on obtient par oxydation) une couche 1 de $SiO_2$ d'épaisseur typiquement comprise entre 0,1 micromètres et quelques micromètres.

On dépose ensuite une couche de résine photosensible (ou un masque superficiel métallique) que l'on insole et développe (optiquement ou à l'aide d'un faisceau d'électrons) de façon à réaliser des ouvertures 5 sensiblement circulaires de diamètre compris entre 0,1 et 2 $\mu m$ au pas de 0,5 à quelques microns. On obtient ainsi une structure telle que représentée en figure 2b.

On grave ensuite (figure 2c) par RIE (Reactive Ionic Etching) la silice sous-jacente en utilisant le masque de résine (ou le masque métallique selon le cas).

On dépose ensuite (figure 2d) par évaporation une couche de matériau tel que de l'or (ou bien d'Ag, Cu, Pt, Pd, Ni, Gd, Mg, Ga, As...) d'épaisseur de 1 nm à 500 nm, qui sera adaptée au diamètre des ouvertures dans $SiO_2$ (plus le diamètre des ouvertures sera faible, plus l'épaisseur de la couche de métal sera elle aussi faible. De préférence, le métal est choisi pour faire avec le silicium un eutectique de bas point de fusion et pour ne pas détériorer les propriétés du whisker de silicium, ou bien pour doper celui-ci de façon utile.

On dissout (figure 2e) ensuite la résine ou bien le masque métallique (dans ce dernier cas on opère une dissolution électrochimique) de façon à éliminer la résine et le dépôt d'Au situé sur la résine précitée ).

L'ensemble des étapes représentées par les figures 2d et 2e est une opération de lift off classique.

A ce stade du procédé on a obtenu des points métalliques (d'or par exemple) localisés avec précision. Par exemple on a pu obtenir une matrice de points d'or.

Au cours de l'étape suivante on procède à la croissance d'un matériau semiconducteur (ou autre) sur les points de métal sélectivement déposés précédemment ; pour cela et toujours selon l'exemple du silicium, on introduit le substrat ainsi obtenu dans un réacteur de dépôt CVD en atmosphère $SiH_4$ + HCl ou $SiH_2Cl_2$ + HCl ou $SiCl_4$, ou encore $SiHCl_3$ + HCl (toujours en utilisant comme gaz porteur $H_2$) et on porte la température entre typiquement 400 et 1000° C.

Dans ces conditions, on obtient la formation d'une phase liquide (AuSi, AuP, AuCu... ) de type eutectique dans chaque micrologement de $SiO_2$.

Ainsi que précédemment expliqué, on a une adsorption préférentielle des molécules de la phase gazeuse dans les gouttelettes de liquide, ce qui induit une anisotropie de croissance locale.

On utilise typiquement un mélange gazeux composé de $SiH_4$ et de HCl afin d'obtenir une sélectivité de dépôt et éviter la nucléation du silicium sur la silice comme cela a été décrit par exemple dans les documents suivants :

– J. O. BORLAND, C. I. DROWLEY
Solid State Technology Août 1985 p. 141
– L. KARAPIPERIS et coll.
Proceeding of the 18Th Int. Conf. on Solid State Devices and Materials TOKYO 1986, p. 713.

De cette manière, on est certain de n'avoir des dépôts qu'au niveau des gouttelettes de liquide permettant la croissance des whiskers (figure 2 f). La figure 2g représente de façon plus détaillée une telle croissance.

On obtient ainsi des réseaux réguliers bidimensionnels de whiskers.

Notamment, si on a réalisé les dépôts de métal sous forme d'une matrice, on peut obtenir une matrice de monocristaux filamentaires (whiskers ).

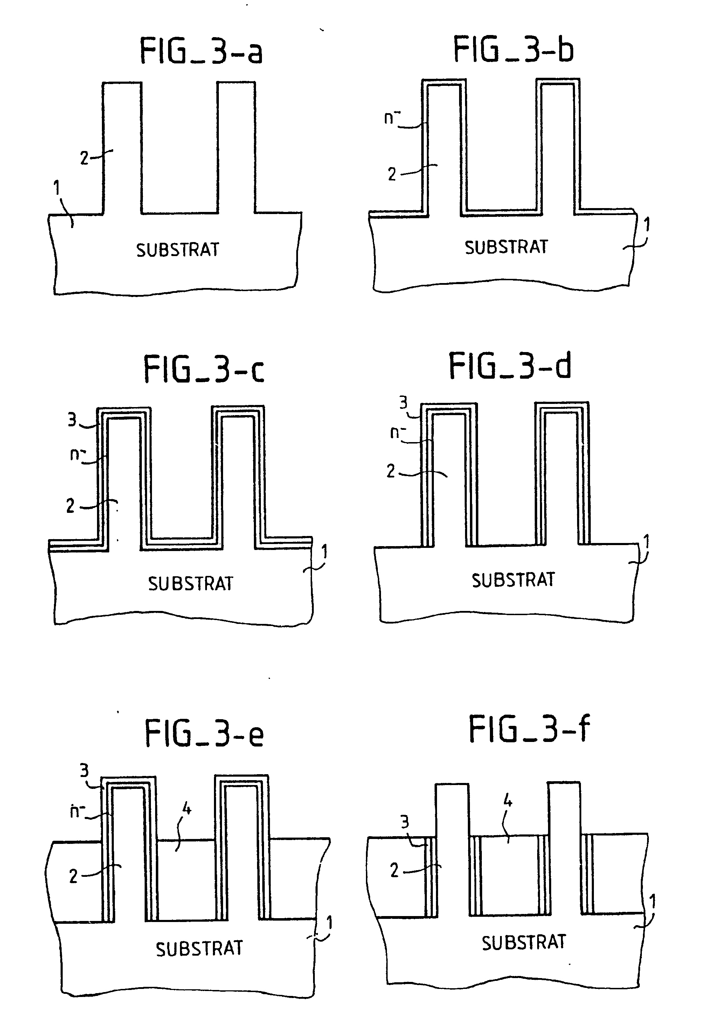

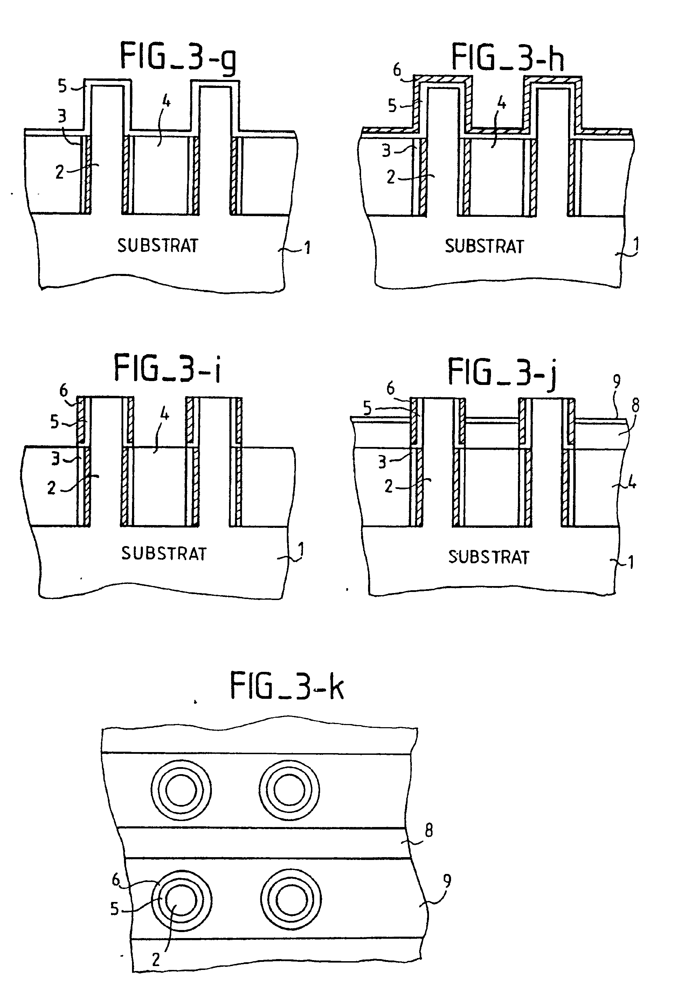

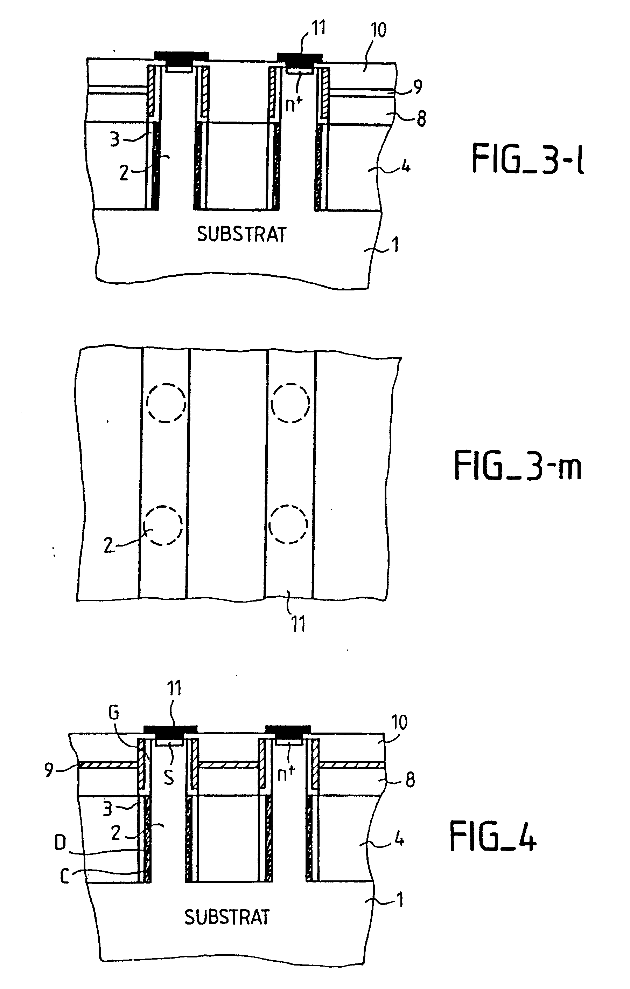

En se reportant aux figures 3a à 3j on va maintenant décrire un procédé de réalisation selon l'invention de mémoires DRAM construites autour d'éléments filamentaires (whiskers) obtenus par exemple par le procédé précédent.

On dispose d'un substrat 1, tel que représenté en figure 3a possédant à sa surface 10 des éléments filamentaires 2 sensiblement perpendiculaires à la surface 1 et disposés en des emplacements de la surface 10 déterminés avec précision.

On procède alors à un dopage n des filaments 2 (figure 3b), le substrat 1 étant protégé par la couche de silice.

Ensuite on recouvre l'ensemble par une couche d'isolant, ce qui peut se faire par oxydation des filaments (figure 3c) ou par dépôt d'isolant.

On procède ensuite à un dépôt de semiconducteur polycristallin 4 de façon à remplir l'espace libre entre les filaments 2 et cela jusqu'à une hauteur limitée des filaments (figure 3e). Ce dépôt est soit direct entre les filaments, soit uniforme et suivi d'une attaque sélective entre polysilicium et isolant qui ne laisse du polysilicium qu'entre les filaments.

Au cours de l'étape suivante représentée en figure 3f, on réalise une attaque sélective (attaque chimique sélective ) pour enlever la couche d'isolant et de semiconducteur dopé $n^-$ de la partie des filaments qui émerge du semiconducteur polycristallin 4.

Comme cela est représenté en figure 3g, la structure est ensuite recouverte d'une couche d'isolant 5 ce qui peut se faire par oxydation, puis une couche de semiconducteur polycristallin 6 est déposée sur l'ensemble (figure 3h).

On procède ensuite à une attaque directionnelle (figure 3i) de façon à enlever la couche d'isolant 5 et le semiconducteur polycristallin 6 à la partie supérieure des filaments et à la surface de la couche 4.

Conformément aux figure 3j et 3k un dépôt d'un matériau isolant 8 est réalisé jusqu'à atteindre la couche 6 des filaments. Sur ce matériau isolant 8 sont déposées des connexions de grilles réalisées sous forme de connexion de ligne (9) tel que cela est représenté en figure 3k.

La structure est ensuite planarisée à l'aide d'un matériau 10 tel que du polyimide de façon à recouvrir l'ensemble des filaments. Des ouvertures d'accès aux faces supérieures des filaments sont pratiquées dans le matériau 10, puis la partie supérieure des filaments est dopée $n^+$. Des connexions de sources 11 sont ensuite réalisées sur ces zones dopées $n^+$ (figure 31). Des connexions 11 peuvent être faites sous forme de connexions de colonnes interconnectant les sources des filaments d'une même colonne de filaments de la matrice. Le dopage $n^+$ et la réalisation des connexions peut utiliser le même système de masquage que celui utilisé pour la réalisation des filaments et décrit précédemment en se reportant aux figures 2a à 2e.

A titre d'exemple, le matériau utilisé pour le substrat est du silicium dopé p. Le matériau utilise pour les couches d'isolant 3 et 5 est du $SiO_2$. Le matériau semiconducteur polycristallin est du silicium polycristallin. Cependant on pourrait utiliser d'autres types de semiconducteurs.

La figure 4 représente un élément de mémoire DRAM tel qu'il est obtenu par le procédé de l'invention.

Le drain D du transistor de commande de cet élément est constitué par une portion de la couche dopée n⁻ du filament 2. La grille G est constituée par une portion de la couche 6 de silicium polycristallin. La source S est constituée par le dopage n⁺ de la face supérieure du filament 2.

Enfin, le condensateur C constituant l'élément mémoire est constitué par une portion de la couche 3 et est connecté d'une part au drain D et, d'autre part, à la couche constituant un plan de masse. On retrouve également sur cette figure 4 les connexions de lignes 9 et les connexions de colonnes 11.

Le procédé de l'invention permet de réaliser des filaments cristallins tels que 2, uniformément répartis et notamment une matrice de filaments. Il permet donc de réaliser une matrice d'éléments mémoire élémentaires qui peuvent être à adressage matriciel à l'aide des conducteurs de lignes et de colonnes tels que les conducteurs 9 et 11.

A titre indicatif, la plus grande dimension de chaque filament mesurée à la surface du substrat peut être environ de 0,1 μm et le pas de répartition des filaments peut être d'environ 0,5 μm. On voit donc qu'il est possible de réaliser une mémoire présentant une très grande densité d'éléments mémoire par unité de surface, par exemple une densité mémoire supérieure à 400 Mbits/cm².

L'invention fournit les avantages suivants :

– les différentes opérations peuvent être réalisées dans un même bâti de dépôt d'oxydation et de diffusion qui a servi à la croissance des filaments, au moins jusqu'à l'opération de remplissage de matériau semiconducteur polycristallin 4 ( figure 3e ).
Cela évite des manipulations qui risqueraient de détériorer les filaments.
– un seul masque (celui qui est utilisé lors de la fabrication du masque d'oxyde définissant des filaments ) peut être utilisé pour la réalisation des ouvertures aux faces supérieures des filaments en vue du dopage n⁺ des filaments.

L'invention est également applicable à la réalisation de transistors à base perméable tels que décrits dans l'article de Carl BOZLER et Gary ALLEY, IEEE Transactions on Electron Devices, ED-27, 1128, 1980.

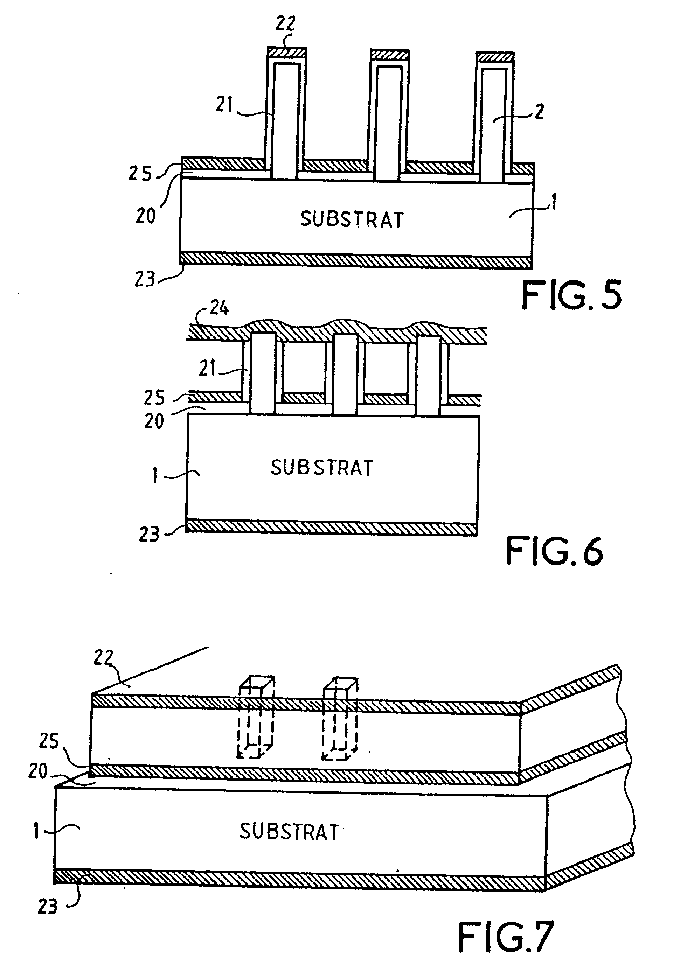

Ce type de transistor obtenu par le procédé de l'invention est tel que représenté en figure 6.

Il comporte un substrat 1 en matériau conducteur faisant office de collecteur et comportant une électrode de contact de collecteur 23. Chaque pilier (filament) 2 est dopé du même type que le substrat et possède à sa partie supérieure un contact d'émetteur 22. Les filaments 2 sont séparés entre eux au niveau du substrat par une couche de contact de base 25.

La réalisation d'un tel transistor se fait de la manière suivante :

1 - sur un substrat 1 sont réalisés des filaments 2 par croissance cristalline comme cela a été décrit précédemment, les différents filaments étant isolés les uns des autres par une couche 20 d'isolant (SiO₂) ;

2 - l'ensemble de filaments est revêtu d'une couche d'isolant 21 (SiO₂) ;

3 - une couche métallique 22, 25 est déposée de manière directionnelle à la partie supérieure des filaments 2 et entre les filaments 2. On obtient ainsi la structure décrite en figure 5 ;

4 - ensuite les espaces entre filaments sont remplis par un matériau de préférence isolant, tel que du polyimide par exemple et on procède à une planarisation à la partie supérieure des filaments ;

5 - le métal 22 et l'isolant 21 situés à la partie supérieure des filaments 2 sont enlevés ;

6 - une couche de métal servent de couche de contact d'émetteur est déposée à la partie supérieure des filaments.

On obtient la structure représentée en figure 6 et représentée en perspective en figure 7.

Chaque transistor obtenu est de type MOSFET ou MISFET.

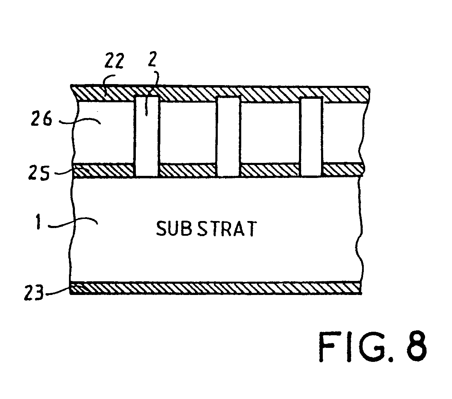

Selon l'invention, il est également possible de réaliser une jonction SCHOTTKY. Pour cela, après avoir réalisé, sur le substrat 1, des filaments 2, on enlève le matériau isolant pouvant exister. On réalise, entre les filaments 2, un dépôt d'une couche métallique 25. L'ensemble est ensuite planarisé à l'aide d'un matériau isolant 26, puis à la partie supérieure des filaments 2 est déposée une couche métallique 22. On obtient ainsi la structure représentée en figure 8.

Il est bien évident que la description qui précède n'a été fournie qu'à titre d'exemple et que d'autres variantes peuvent être envisagées. Notamment, les types de matériaux peuvent être différents de ceux indiqués précédemment ainsi que les exemples de dimensions.

**Revendications**

1. Procédé de réalisation de dispositifs électroniques caractérisé en ce qu'il comporte les étapes suivantes :

   – une étape de réalisation sur une surface (10) d'un substrat (1) d'au moins un filament cristallin (2) sensiblement perpendiculaire à la surface du substrat ;
   – une étape de réalisation autour de chaque filament d'un composant électronique ;
   – une étape de planarisation au niveau de la partie supérieure des filaments à l'aide d'un matériau isolant ;
   – une étape de réalisation de contacts à la partie supérieure de chaque filament.

2. Procédé de réalisation selon la revendication 1, caractérisé en ce que la première étape comporte les différentes phases suivantes :
   - une première phase de réalisation sur un substrat d'une première couche (1) d'un matériau sur lequel il ne pourra y avoir ni croissance, ni nucléation du matériau à faire croître dans les étapes ultérieures ;
   - une deuxième phase de réalisation dans ladite première couche (1) d'au moins une ouverture (5) ;
   - une troisième phase de dépôt sélectif dans ladite ouverture (5) d'un matériau dans lequel, lorsqu'il est liquide, le matériau à faire croître peut être absorbé ;
   - une quatrième phase de croissance en phase vapeur, dans ladite ouverture (5), du matériau à faire croître.

3. Procédé de réalisation de mémoire selon la revendication 2, caractérisé en ce qu'il comporte les étapes suivantes :
   - une première étape de réalisation sur une surface (10) d'un substrat (1) d'au moins un filament cristallin (2) sensiblement perpendiculaire à la surface du substrat ;
   - une deuxième étape de dopage de type $n^-$ de la surface du substrat du filament cristallin (2);
   - une troisième étape de réalisation d'une première couche d'isolation (3) sur la surface dopée de type $n^-$ ;
   - une quatrième étape de dépôt de semiconducteur polycristallin ( 14) sur le substrat jusqu'à une hauteur limitée du filament ;
   - une cinquième étape d'attaque sélective de la première couche d'isolation (3) et de la couche $n^-$ du filament ;
   - une sixième étape de dépôt d'une deuxième couche d'isolation (5);
   - une septième étape de dépôt d'une couche (6) de semiconducteur polycristallin ;
   - une huitième étape d'attaque directionnelle de façon à enlever la deuxième couche d'isolation (5) et la couche de semiconducteur polycristallin ( 6 ) à la partie supérieure du filament et de part et d'autre du filament ;
   - une neuvième étape de dopage $n^+$ de la partie supérieure du filament et de réalisation d'une électrode de source à cette partie supérieure.

4. Procédé de réalisation d'un transistor à base perméable selon la revendication 2, caractérisé en ce qu'il comporte les étapes suivantes :
   - une étape de réalisation sur une surface d'un substrat (1) d'au moins un filament cristallin (2) sensiblement perpendiculaire à une face du substrat ;
   - une étape de réalisation sur ladite face du substrat et sur le filament d'une couche d'isolant (20) ;
   - une étape de réalisation sur l'isolant (20) recouvrant ladite face du substrat (1) et sur la face opposée, de couches (23, 25) de matériaux métalliques ;
   - une étape de planarisation à l'aide d'un matériau isolant de la partie supérieure du filament ;
   - une étape d'enlèvement de l'isolant situé à la partie supérieure du filament ;
   - une étape de dépôt d'un matériau métallique (22) à la partie supérieure du filament.

5. Procédé de réalisation d'un transistor à base perméable selon la revendication 1, caractérisé en ce qu'il comporte les étapes suivantes :
   - une première étape de réalisation sur une surface d'un substrat (1) d'au moins un filament cristallin (2) sensiblement perpendiculaire à une face du substrat ;
   - une troisième étape de réalisation sur ladite face du substrat (1) et sur la face opposée de couches (23, 25) de matériaux métalliques ;
   - une étape de dépôt d'un matériau métallique (22) à la partie supérieure du filament.

FIG_1

1 ⌐⌐ SiO$_2$

Si (111)

**FIG_2-a**

0,1μ

Résine

SiO$_2$

Si (111)

**FIG_2-b**

5

Résine

SiO$_2$

Si (111)

**FIG_2-c**

Evaporation Au

Résine

SiO$_2$

Si(111)

**FIG_2-d**

Au

SiO$_2$

Si(111)

**FIG_2-e**

goutte Au Si

Whisker Si

SiO$_2$

Si(111)

**FIG_2-f**

## FIG_3-a

## FIG_3-b

## FIG_3-c

## FIG_3-d

## FIG_3-e

## FIG_3-f

## FIG_3-g

5
3
2
4
SUBSTRAT
1

## FIG_3-h

6
5
3
2
4
SUBSTRAT
1

## FIG_3-i

6
5
3
2
4
SUBSTRAT
1

## FIG_3-j

6
5
3
2
9
8
4
SUBSTRAT
1

## FIG_3-k

8
6
5
9
2

FIG_3-l

FIG_3-m

FIG_4

FIG. 5

FIG. 6

FIG. 7

SUBSTRAT

FIG. 8

Office européen
des brevets

**RAPPORT DE RECHERCHE EUROPEENNE**

Numero de la demande

EP 91 40 0484

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-3 574 008 (E.J. RICE)<br>* Colonne 1, ligne 44 - colonne 2, ligne 6; figures 1a-1e *<br>--- | 1 | H 01 L 21/82<br>H 01 L 21/20<br>H 01 L 21/335<br>H 01 L 27/108 |
| A | FR-A-2 452 784 (HITACHI)<br>* Page 6, ligne 38 - page 8, ligne 13; figures *<br>--- | 1,5 | |
| A | PATENT ABSTRACTS OF JAPAN, vol. 11, no. 110, (E-496)[2257], 7 avril 1987; & JP-A-61 258 467 (HITACHI) 15-11-1986<br>* En entier *<br>--- | 2 | |
| A | EP-A-0 198 590 (TOSHIBA)<br>* Colonne 7, ligne 36 - colonne 10, ligne 2; figures 4a-4g; revendications 7-11 *<br>--- | 1,3 | |
| A | EP-A-0 344 447 (TEXAS INSTRUMENTS)<br>* Figures 5a-5p; colonne 7, ligne 21 - colonne 15, ligne 17 *<br>--- | 1,3 | DOMAINES TECHNIQUES RECHERCHES (Int. Cl.5) |
| A | EP-A-0 333 426 (TOSHIBA)<br>* Figures 3,4; colonne 11, ligne 4 - colonne 14, ligne 1 *<br>--- | 1,3 | H 01 L |
| A | EP-A-0 230 840 (ETAT FRANCAIS et al.)<br>* Page 3, ligne 15 - page 4, ligne 5; figures *<br>----- | 4 | |

Le présent rapport a été établi pour toutes les revendications

| Lieu de la recherche | Date d'achèvement de la recherche | Examinateur |
|---|---|---|
| LA HAYE | 22-05-1991 | GELEBART Y.C.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)